Europäisches Patentamt

European Patent Office

Office européen des brevets

(11) Publication number: **0 392 242**
**A2**

## (12) EUROPEAN PATENT APPLICATION

(21) Application number: **90105664.8**

(22) Date of filing: **26.03.90**

(51) Int. Cl.5: **H01L 23/498, H01L 25/10**

(30) Priority: **10.04.89 DE 3911711**

(43) Date of publication of application:
**17.10.90 Bulletin 90/42**

(84) Designated Contracting States:
**DE FR GB**

(71) Applicant: **International Business Machines Corporation**
**Old Orchard Road**
**Armonk, N.Y. 10504(US)**

(72) Inventor: **Kelley, Gordon A.**
**37 East Street**
**Essex Junction, Vermont 05452(US)**

Inventor: **Strähle, Werner, Dipl.-Ing.**
**Lärchenstrasse 19**
**D-7405 Dettenhausen(DE)**
Inventor: **North, Richard W.**
**RR2 3052C**
**Fairfax, Vermont 05454(US)**
Inventor: **Hinrichsmeyer, Kurt**
**Tessiner Strasse 28**
**D-7032 Sindelfingen 7(DE)**

(74) Representative: **Klocke, Peter, Dipl.-Ing.**
**IBM Deutschland GmbH Patentwesen und**
**Urheberrecht Schönaicher Strasse 220**
**D-7030 Böblingen(DE)**

(54) **Module assembly with intergrated semiconductor chip and chip carrier.**

(57) Module (10) comprises a chip carrier (1) and an integrated semiconductor chip 9 having its contact pads (11), facing the chip carrier, fixed in a recess (5) of the latter. Through a slot (3) in chip carrier (1), contact pads (11 are connected by lead wires (12) to conductors 8 on the top side (2) of carrier (1). The entire module (10) has a height ranging from 0.8 to 1.2 mm and thus permits increasing the packaging density of standard EDP systems. In addition, such modules are more readily producible than DIP modules with molded plastic housings. A module package comprising four such modules has a height that is noticeably less than that of comparable module packages with standard modules. By arranging a plurality of such modules with different chips adjacent to each other, a card may be obtained which as a basic card acts as an identification and/or a credit card.

FIG. 3A

## Module assembly with integrated semiconductor chip and chip carrier

The invention concerns a module with a chip carrier and an integrated semiconductor chip as well as a module stack and the use of the modules.

Currently marketed modules with integrated semiconductor chips (IC chips), in particular memory chips, require a large amount of space so that only a limited number of such modules (DIP = dual in-line package) stacked on a card can be installed in EDP systems. A reduction of the overall height of the individual modules would permit an enormous increase in memory space, with the space requirements for the EDP systems remaining unchanged. In addition, the production of such chips and modules and the time needed for testing them constitute a substantial cost factor, as currently they account for roughly one third of the total production cost. Therefore, the time such components spend in the semiconductor plant should be reduced to a minimum.

From IBM Technical Diclosure Bulletin, Vol. 8, No. 10, March 1966, p. 1314 a module is known which comprises a ceramic carrier consisting of several ceramic layers with conductors and a recess on one side accommodating the monolithic circuit. The monolithic circuit is connected by conductors in the ceramic layers to the opposite side of the carrier. The carrier side with the recess is provided with a thin metal foil to improve the cooling properties of the circuit. The chip carrier described in the above-mentioned article is complicated to produce and thus very expensive. Connection of the chip is relatively difficult and requires special measures. The entire layout of the chip carrier is unduly high relative to the desired dimensions, so that such a structure is unsuitable in particular for use in modules with memory chips.

Also known are memories and processors which, as previously mentioned, are plastic molded (DIP). Such modules, too, have the disadvantage that they are still relatively high and that they can only be finally tested after molding, i.e., after completion of the product. The height of the finished component does not only limit the number of modules that can be stacked on a card but also requires long conductor paths to decoupling capacitors that have to be arranged on the card carrying the components. In addition, it is highly time-consuming to exchange defective modules during the stacking of memory modules.

Therefore, it is essential to provide modules of minimum flatness and to simultaneously simplify their production.

This problem is solved by a module as claimed which is provided with a chip carrier with a top and a bottom side extending substantially parallel to each other. The chip carrier may have a circular or a square shape but usually it is adapted to the shape of the chips, so that the shape commonly used at present is square. The bottom side of the chip carrier is provided with at least one recess and at least one slot which in the area of the recess extends to the top side of the carrier. The recess serves to accommodate the chip, with the contact pads of the chip facing the chip carrier. The slot(s) is (are) arranged in the recess such that the contact pads on the chip are positioned in the area of the slot(s). Thus, the slot in the recess may be provided at an arbitrary point, depending upon the arrangement of the contact pads on the chip. It is possible, for example, to provide only one slot in the center or at one edge or to have three perpendicularly arranged slots for a larger chip. For vertically mounted modules, in which one side of the contact pins is attached to the chip carrier, it may be favourable to have the slot closely adjacent to the pins. Electrical conductors provided at least on the top side of the chip carrier may be connected to conductors on the bottom side of the chip carrier by plated-through holes. It is essential to provide the top side with terminals for connection to the chip. Therefore, the through holes are to be regarded as conductors. In addition, the module comprises lead wires which through the slot(s) connect the contact pads on the chip to the conductors on the bottom side of the carrier. The contact pads on the chip may be connected to the conductors by known techniques, such as wire bonding, TAB (tape automated bonding) or the like. The chip is retained in the recess by suitable measures, such as gluing. Neither the back side of the chip nor the bottom side of the chip carrier have to be sealed, so that the back side of the chip is effectively cooled by air current. Normally, the top side of the chip carrier is sealed in the area of the lead wires and the contact pads of the chip to prevent damage to the conductors.

It is expedient for the back side of the chip and the bottom side of the carrier to form one plane so that the entire chip is embedded in the carrier and protected.

According to a further advantageous embodiment, the slots are bevelled at the edges to which lead wires are applied. This renders the contact pads on the chip readily accessible when the former and the conductors on the surface of the chip carrier are connected. The thickness of the carrier with the embedded chip preferably is 0.8 to 1.2 mm and that of the carrier in the area of the recess 0.2 to 0.5 mm.

The carrier is preferably made of a multilayer laminate or a ceramic material. In the case of highly temperature-resistant polyimide, the recess is fabricated by milling, whereas in the case of a multilayer laminate, the individual layers may already contain the recess or slot in the desired shape and arrangement. The laminate material may be metallized on one or both sides. Reinforced polyimides or ceramics are necessary for a carrier which is stable during testing (burn-in), soldering and future handling.

The module may comprise passive and/or active components, the advantage of such a structure being that these components are arranged closely adjacent to the chip. In such an environment the effect of, say, decoupling capacitors is particularly pronounced. For voltage adaptation, for example, active components may also be arranged immediately adjacent to the chip on the carrier.

A module of the above-described kind has the advantage that its height is very small, that the lines from the contact pads on the chip to the terminals on the top side of the chip carrier have roughly the same length and are very short, that the decoupling capacitors are arranged immediately adjacent to the chip, that the back side of the chip is effectively cooled, and that such a structure is suitable for future chip generations exceeding 1 megabit. A chip thus designed has the additional advantage that it is easier and less expensive to produce, as several modules, interconnected by their chip carriers, may be simultaneously treated and tested.

The modules designed according to the invention permit producing module stacks of a particularly small height. For this purpose, the individual modules are connected by S-shaped connector clips with embedded tin solder at least at one point of contact with the carrier and at the point of contact with the next module to be connected. This permits soldering a stack of modules in a single step. The height of four such modules is so small that it would be conceivable to use chips of which only 25 or 50 % are non-defective to form a functionable memory of, say, 1 megabit.

According to a further advantageous embodiment of the invention, several modules arranged adjacent to and permanently linked with each may be used for a card to be employed as an identification and/or a credit card or the like. In such a case, the various modules have one common carrier comprising on its top side conductors for electrically interconnecting the modules. The conductors may be arranged on at least one surface or between the laminates. Such a card may accommodate one processor and one memory chip. Its overall thickness exceeds that of modules arranged adjacent to each other only slightly. Adequate card stability is obtained by using reinforced polyimide.

Further advantages may be seen from embodiments which are described below with reference to the accompanying drawings, in which

Fig. 1 is a plan view and a longitudinal and cross-sectional view of the chip carrier;

Fig. 2 is a plan view of the module;

Fig. 3 is a cross-sectional view of the module and a cross-sectional view of the module stack with four modules stacked on top of each other, and

Fig. 4 is a plan view of a schematic of a card with two modules arranged adjacent to each other for use as an identification and/or a credit card.

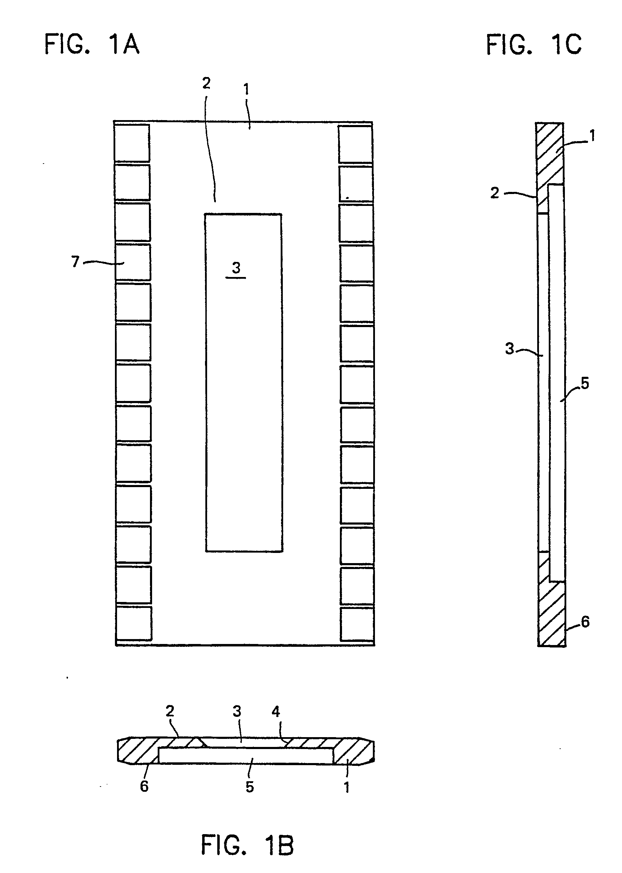

In Fig. 1, Fig. 1A shows a chip carrier 1 with its top side 2, the slot 3 as well schematically represented contact pads 7 on the long sides of the chip carrier. The chip carrier 1 is rectangularly shaped and adapted to the shape of the chip to be accommodated later on. Needless to say, any other adapted shape would be equally suitable. Slot 3 of the chip carrier 1, illustrated in Fig. 1, is positioned absolutely perpendicularly in the carrier center, since the carrier serves to accommodate a chip whose contact pads are arranged in the center. For another chip configuration, the slot may be arranged on the side or the chip carrier may be provided with several slots.

Fig. 1B is a cross-sectional view of the chip carrier 1. This view shows that slot 3, positioned on the top side 2, is bevelled 4 to be more readily accessible for chip wiring. Slot 3 terminates in a recess 5 on the bottom side 6 of the chip carrier 1. The width of recess 5 in the horizontal exceeds that of slot 3, as recess 5 serves to accommodate and reliably retain the chip.

The longitudinal cross-section (Fig. 1C) of the chip carrier 1 shows that the width of recess 5 in the vertical also exceeds that of slot 3, so that the chip to be arranged in recess 5 may be readily accommodated and reliably retained therein. Bevelling of the chip carrier is not required along the narrow sides of slot 3, unless lead wires are to be led across them.

At certain points the recess may be slightly larger. than the chip to permit the introduction of glue, sealing material or the like.

The chip carrier is made of reinforced polyimide or a ceramic material. When a polyimide is used, it is advantageous for the individual layers of the laminate to be provided with openings whose size corresponds to that of slot 3 or recess 5 to eliminate rework. Similar results may be achieved with a ceramic material consisting of several molded or punched layers. With such a layout, the chip carrier has a thickness of 0.8 to 1.2 mm, even if the chip is integrated, as will be explained later on. The thickness of the chip carrier 1 in the area of the recess 5 is only 0.2 to 0.5 mm.

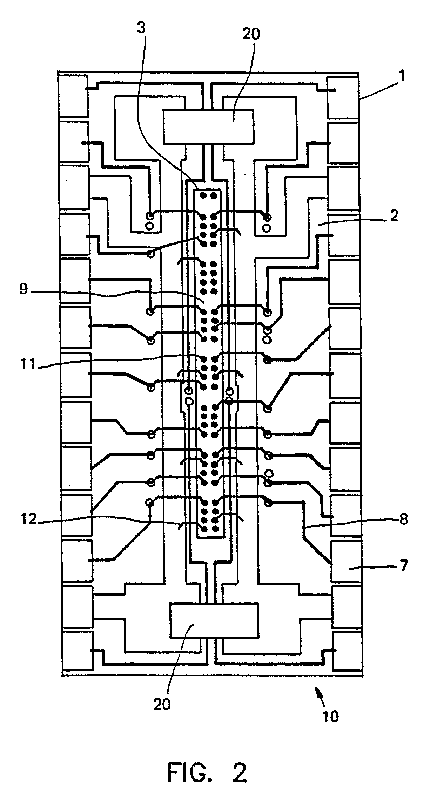

Fig. 2 is a plan view of module 10 showing the top side 2 of chip carrier 1. On the top side 2 of the chip carrier 1, conductors 8 are arranged which are connected to contact pads 7 at the edge of the chip carrier. The bottom side 6 of the chip carrier 1 may also be provided with conductors which through vias in the chip carrier are connected to the conductors on the top side (not shown). The conductors 8 on the top side 2 of the chip carrier 1 are connected by lead wires to the contact pads 11 on the top side of chip 9 through slot 3. Contact pads 11 on chip 9 are connected to conductors 8 by known techniques, such as wire bonding, TAB or the like. On carrier 1, active components 20 (decoupling capacitor, diode) may be arranged closely adjacent to the chip.

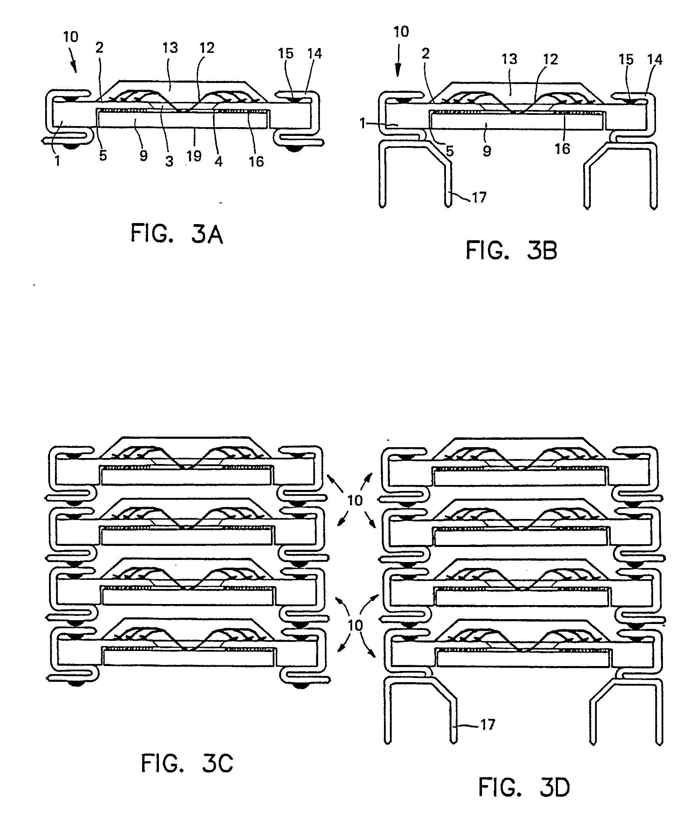

Fig. 3 is a cross-sectional view of finished modules. In Figs. 3A and 3B, one chip 9 each is fixed to a chip carrier 1. Figs. 3A and 3B differ in that the module of Fig. 3A is soldered to a card (SMT = surface mounted technology), whereas the module of Fig. 3B has pins by which it is soldered to a card with holes (PIH = pin-in-hole).

Chip 9 is fixed in recess 5 by a glue 16. Through slot 3, lead wires 12 connect the contact pads on the top side of chip 9 to conductors on the top side 2 of the chip carrier 1. Slot 3 is bevelled 4 in the area of the lead wires 12. The top side of chip 9 and the lead wires 12 are sealed by sealing means 13. The long sides of the chip carrier 1 are provided with S-shaped connector clips 14 with molded tin solder 15 at the contact point of the terminal and the top side 2 of the chip carrier 1 and at the point where the terminals with the carrier plate, on which the module is mounted, are fixed. The back side 19 of chip 9 forms one plane with the bottom side 6 of the carrier 1, so that the chip is fully protected by the recess 5 in carrier 1. The back side 19 remains free, so that chip 9 is adequately cooled by air. In Fig. 3B, pins 17 are provided in lieu of tin solder. The melting point of the molded tin solder exceeds the temperature of the subsequent soldering step, as the modules with the connector clips are finished before they are finally fixed to the carrier plate.

This is shown in particular in conjunction with the module stacks of Figs. 3C and 3D. The design of the individual modules 10 is identical to that of module 10 in Fig. 3A. Only the bottom-most module 10 in Fig. 3D is provided with pins 17 similar to the module of Fig. 3D, by which it is fixed to the carrier plate. Such module stacks may be readily formed by using the module according to the invention. They are extremely flat. A module stack of Figs. 3C and 3D has a height of about 10 mm measured from the top side of the carrier plate. This is a great advantage over existing module stacks, as the reduced height doubles the packaging density.

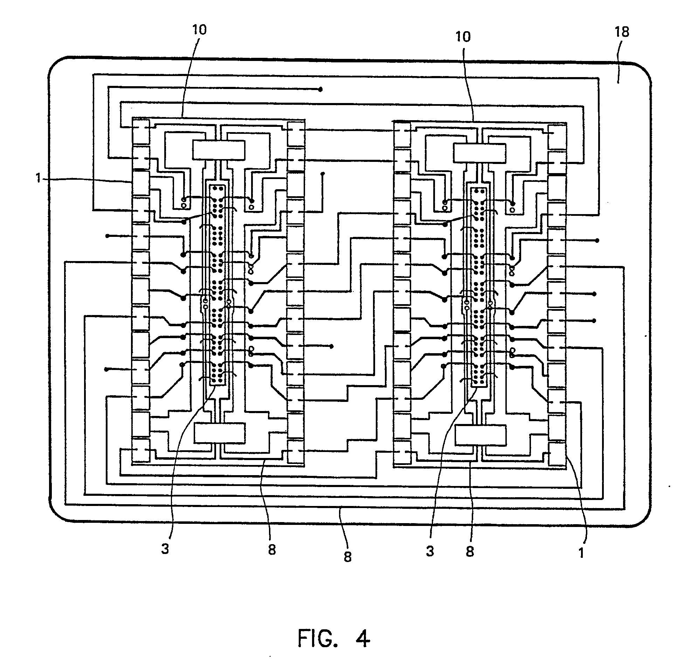

Fig. 4 is a schematic of a card with two adjacent modules connected by conductors 8. Conductors 8 may be arranged on the surface or between the laminates. The chips in the modules 10 may differ, i.e., there may be processor and memory chips. The card 18 is made of the same material as the chip carriers of the respective modules. Card 18 may be provided with conductors both on the top and the bottom side. The conductors are connected by vias. Such a card of, say, polyimide, has an adequate stability over its entire thickness of 0.8 to 1.2 mm, so that it may be used as an identification and/or a credit card. For this purpose, card 18 is sealed by suitable material containing characters and a magnetic stripe.

## Claims

1. Module (10) comprising
a chip carrier (1) with a top and a bottom side (2, 6), extending substantially parallel to each other, a recess (5) in the bottom side, at least one slot (3) which in the area of the recess extends to the top side of the carrier, and electrical conductors (8) arranged at least on the top side,
an integrated semiconductor chip (9) having contact pads (11) facing the chip carrier and being arranged in the recess (5) such that the contact pads are positioned in the region of the slot(s) (3), and
lead wires (12) which through slot(s) (3) connect the contact pads (11) on the chip (9) to conductors (8) on the top side (2) of the carrier (1).

2. Module as claimed in claim 1, wherein the back side (19) of the chip (9) and the bottom side (6) of the carrier (1) form one plane.

3. Module as claimed in claim 1 or 2, wherein the slot(s) (3) is (are) bevelled (4) along the edges across which the lead wires (12) are led.

4. Module as claimed in any one of the preceding claims, wherein the carrier (1) with the embedded chip (9) has a thickness of 0.8 to 1.2 mm and the thickness of the carrier in the region of the recess (5) is 0.2 to 0.5 mm.

5. Module as claimed in any one of the preceding claims, wherein the carrier (1) is made of a reinforced polyimide, preferably a multilayer laminate, or of a ceramic material.

6. Module as claimed in any one of the preceding claims, wherein passive and/or active components (20) are arranged on the carrier.

7. Module stack with at least two modules (10) as claimed in any one of the preceding claims, wherein the individual modules are connected by S-shaped connector clips (14) which are provided with molded tin solder (15) at least at one point of contact with the carrier (1) and the point of contact with the respective next module (10).

8. Use of a plurality of adjacent permanently interconnected modules (10) as claimed in any one of the preceding claims 1 to 5 for a card (18) to be employed as an identification and/or a credit card, wherein all modules (10) have a common carrier provided with conductors (8) for electrically interconnecting the modules.

EP 0 392 242 A2

FIG. 1A

FIG. 1C

FIG. 1B

FIG. 2

FIG. 3A

FIG. 3B

FIG. 3C

FIG. 3D

FIG. 4